# DEMANDE DE BREVET EUROPEEN

(11) **EP 4 764 530 A1**
(43) Date de publication de la demande: **24.06.2026**
(21) Numéro de dépôt: 25221817.7
(22) Date de dépôt: 09.12.2025
(51) Int. Cl.: G01R 31/382, H01M 8/00

(54) **DISPOSITIF ET PROCÉDÉ DE MESURE D'UN CHAMP MAGNÉTIQUE ÉMIS PAR UN OBJET**

(30) Priorité: 18.12.2024 FR 2414475
(71) Demandeur: Commissariat à l'Energie Atomique et aux Energies Alternatives, 75015 Paris (FR); Université Grenoble Alpes, 38400 Saint-Martin-d'Hères (FR); Institut Polytechnique de Grenoble, 38000 Grenoble (FR); Centre National de la Recherche Scientifique, 75016 Paris (FR)
(72) Inventeur: THOMAS, Rémy, 38054 Grenoble Cedex 09 (FR); HEIRIES, Vincent, 38054 Grenoble Cedex 09 (FR); ROSINI, Sébastien, 38054 Grenoble Cedex 09 (FR); CHADEBEC, Olivier, 38000 38054 Grenoble (FR); CAUFFET, Gilles, 38210 Saint-Quentin-sur-Isère (FR); BULTEL, Yann, 38340 Voreppe (FR)
(74) Mandataire: Cabinet Beaumont

(57) **Abrégé**

La présente description concerne un dispositif (300) de mesure d'un champ magnétique (B) émis par un objet (100) comprenant un capteur matriciel (304) comprenant une matrice de capteurs magnétiques (302) configurés pour acquérir des mesures successives du champ magnétique, une charge commandable (314) destinée à être connectée électriquement à l'objet (100), et un module (216) configuré pour commander la charge commandable (314) pour faire varier le courant circulant dans l'objet (100) au cours des acquisitions des mesures successives du champ magnétique et pour recevoir les mesures successives du champ magnétique.

## Description

### Domaine technique

La présente description concerne de façon générale un dispositif et un procédé de mesure d'un champ magnétique émis par un objet comprenant un empilement de cellules électrochimiques.

### Technique antérieure

Un exemple d'objet comprenant un empilement de cellules électrochimiques correspond à une pile à combustible qui comprend un empilement de cellules élémentaires constituées d'une plaque bipolaire et d'un assemblage membrane électrode.

Chaque cellule élémentaire fonctionne pour convertir l'énergie produite par la réaction de l'oxygène et de l'hydrogène en énergie électrique. Plus précisément, la pile à combustible est alimentée en hydrogène (combustible) et en oxygène (de l'air) et induit des réactions électrochimiques de ceux-ci au niveau d'électrodes pour la production d'eau et d'électricité.

Chaque cellule élémentaire est constituée d'un assemblage d'une membrane perméable aux ions, d'une électrode à air et d'une électrode à combustible qui sont fixées sur des faces opposées de la membrane, et de plaques maintenant l'ensemble. Les plaques sont équipées de voies d'écoulement de gaz. La cellule élémentaire est alimentée en oxygène au niveau de l'électrode à air et en hydrogène au niveau de l'électrode à combustible pour produire de l'électricité. Les plaques permettent la distribution des réactifs, la collecte du courant électrique et la gestion de la chaleur.

L'un des objectifs du fonctionnement d'une pile à combustible est de produire le plus d'énergie électrique possible avec la plus petite quantité de gaz combustible (hydrogène gazeux) et d'air (oxygène gazeux).

Dans ce but, il est souhaitable que la répartition des réactions électrochimiques soit la plus uniforme possible pour optimiser l'efficacité et la durée de vie de la pile à combustible. Une répartition uniforme des réactions électrochimiques correspond à une distribution uniforme du courant dans les plaques. De ce fait, c'est la distribution du courant qui est généralement observée. Les plaques sont donc conçues pour avoir une géométrie et une structure qui conduisent à l'obtention d'une distribution uniforme du courant électrique. Des simulations numériques et des essais expérimentaux peuvent être réalisés pour optimiser la conception des plaques.

Pour déterminer la densité de courant dans les plaques de la pile à combustible, un procédé non invasif met en oeuvre des capteurs de champ magnétique qui sont disposés en couronne autour de l'empilement de cellules élémentaires dans un plan orthogonal à la direction d'empilement des cellules élémentaires. La couronne de capteurs de champ magnétique est déplacée selon la direction d'empilement des cellules élémentaires pour mesurer le champ magnétique à l'extérieur de la pile à combustible successivement dans plusieurs plans orthogonaux à la direction d'empilement des cellules élémentaires. La densité de courant est alors déterminée par inversion d'un modèle de comportement magnétique de la pile à combustible à partir des mesures de champ magnétique.

Un inconvénient d'un tel procédé de mesure du champ magnétique est qu'il ne permet une observation que lorsque la pile à combustible fonctionne en régime stable et continu pour que le point de fonctionnement de la pile à combustible soit le même pour chaque acquisition de mesures de champ magnétique successifs dans les plans orthogonaux à la direction d'empilement des cellules élémentaires. En outre, la durée du procédé de mesure du champ magnétique peut être importante.

### Résumé de l'invention

Un mode de réalisation pallie tout ou partie des inconvénients des dispositifs et des procédés de mesure d'un champ magnétique connus.

Un mode de réalisation prévoit un dispositif de mesure d'un champ magnétique émis par un objet comprenant un capteur matriciel comprenant une matrice de capteurs magnétiques configurés pour acquérir des mesures successives du champ magnétique, une charge commandable destinée à être connectée électriquement à l'objet, et un module configuré pour commander la charge commandable pour faire varier le courant circulant dans l'objet au cours des acquisitions des mesures successives du champ magnétique et pour recevoir les mesures successives du champ magnétique.

Selon un mode de réalisation, le dispositif comprend au moins deux capteurs matriciels.

Selon un mode de réalisation, ladite au moins une matrice de capteurs magnétiques comprend un circuit électronique de filtrage des mesures successives du champ magnétique.

Selon un mode de réalisation, le dispositif comprend en outre un capteur de l'intensité du courant circulant dans l'objet et un capteur de tension destiné à mesurer la tension entre deux éléments de l'objet.

Un mode de réalisation prévoit également un système comprenant un objet et un dispositif de mesure de mesure d'un champ magnétique émis par l'objet tel que défini précédemment, les capteurs magnétiques étant configurés pour acquérir des mesures successives du champ magnétique émis par l'objet, la charge commandable étant connectée électriquement à l'objet, et le module étant configuré pour commander la charge commandable pour faire varier le courant circulant dans l'objet au cours des acquisitions des mesures successives du champ magnétique et pour recevoir les mesures successives du champ magnétique.

Selon un mode de réalisation, l'objet comprend des faces latérales externes et le dispositif de mesure du champ magnétique comprend un capteur matriciel sur chaque face latérale externe.

Selon un mode de réalisation, l'objet est une pile à combustible, un électrolyseur, ou une batterie d'accumulateurs électriques.

Selon un mode de réalisation, le capteur de tension est configuré pour mesurer la tension entre deux éléments de l'objet au cours de la variation du courant circulant dans l'objet.

Selon un mode de réalisation, les capteurs magnétiques sont fixes par rapport à l'objet pendant l'acquisition de mesures successives du champ magnétique.

Un mode de réalisation prévoit également un procédé de mesure d'un champ magnétique émis par un objet comprenant la connexion électrique d'une charge commandable à l'objet, l'acquisition de mesures successives du champ magnétique par des capteurs magnétiques d'un capteur matriciel comprenant une matrice desdits capteurs magnétiques, et la commande de la charge commandable pour faire varier le courant circulant dans l'objet au cours des acquisitions des mesures successives du champ magnétique.

Selon un mode de réalisation, le procédé comprend le filtrage fréquentiel des mesures successives du champ magnétique.

Selon un mode de réalisation, le procédé comprend la détermination de la densité de courant dans l'objet à partir des mesures successives du champ magnétique.

Selon un mode de réalisation, le procédé comprend les mesures successives du courant circulant dans l'objet et de la tension entre deux éléments de l'objet au cours de la variation du courant circulant dans l'objet et la détermination d'une impédance à partir des mesures du courant et de la tension.

Selon un mode de réalisation, le courant varie selon une forme d'onde sinusoïdale, ou carrée, ou alternant entre deux valeurs selon une séquence pseudo-aléatoire.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma d'un mode de réalisation d'un système comprenant une pile à combustible et un dispositif de mesure du champ magnétique dans la pile à combustible ;
la figure 2 est une vue en perspective, partielle et schématique, d'une partie du système de la figure 1 ;
la figure 3 est une vue en perspective, partielle et schématique, de la pile à combustible de la figure 1 ;
la figure 4 est une vue en coupe, partielle et schématique, de la pile à combustible de la figure 3 ;
la figure 5 est un schéma par blocs illustrant un mode de réalisation d'un procédé de détermination de la densité de courant dans une pile à combustible par le dispositif de mesure de la figure 1 ;
la figure 6 est une image schématique d'un exemple de la densité de courant dans une pile à combustible obtenue par la mise en oeuvre du procédé de détermination de la densité de courant dans une pile à combustible de la figure 5 ; et

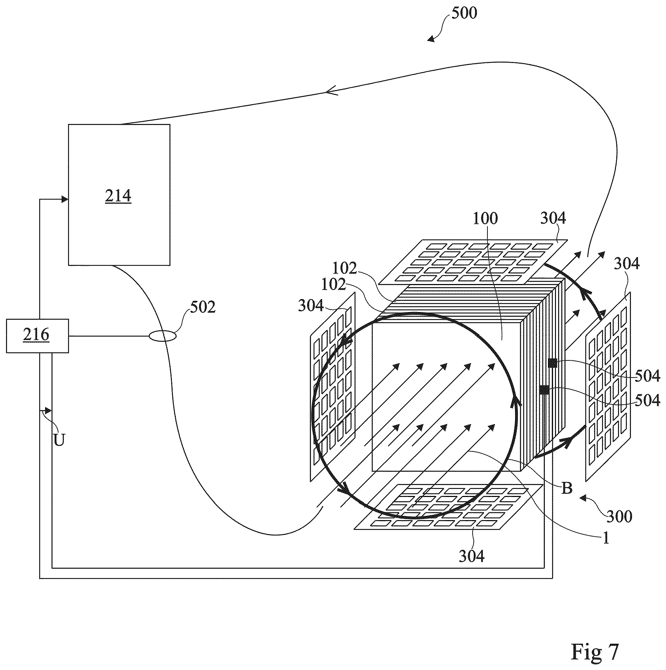

la figure 7 est une vue en perspective, partielle et schématique, d'un autre mode de réalisation d'un système comprenant une pile à combustible et un dispositif de mesure de champ magnétique dans la pile à combustible.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Des modes de réalisation d'un dispositif et d'un procédé de mesure de champ magnétique dans un objet comprenant un empilement de cellules électrochimiques vont être décrit dans le cas où l'objet correspond à une pile à combustible.

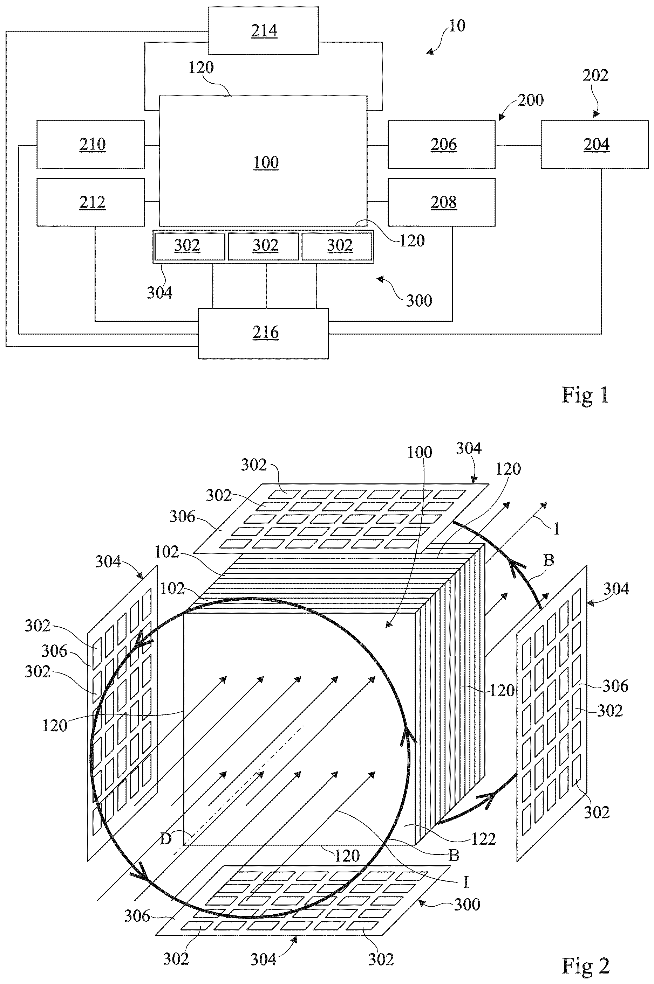

La figure 1 est un schéma d'un système 10 comprenant une pile à combustible 100, un dispositif 200 de commande de la pile à combustible 100 et un dispositif 300 de mesure de champ magnétique dans la pile à combustible 100 et la figure 2 est une vue en perspective, partielle et schématique, de la pile à combustible 100 et du dispositif 300 de mesure de champ magnétique du système 10 de la figure 1.

La pile à combustible 100 comprend un empilement de piles à combustibles élémentaires 102, représentées en figure 2, les piles à combustible élémentaires 102 étant également appelées cellules par la suite. Les piles à combustible élémentaires 102 sont empilées selon une direction d'empilement D, également appelée direction longitudinale de la pile à combustible 100.

Le dispositif 200 de commande de la pile à combustible 100 comprend un dispositif 202 d'alimentation de la pile à combustible 100 en air, comprenant par exemple une pompe à air 204 et un humidificateur 206, un dispositif d'évacuation d'air 208, un dispositif 210 d'alimentation de la pile à combustible 100 en hydrogène, et un dispositif 212 d'évacuation d'hydrogène. Le dispositif 200 de commande de la pile à combustible 100 comprend en outre une charge commandable 214 connectée à la pile à combustible 100 et dans laquelle circule le courant fourni par la pile à combustible 100. Le dispositif 200 de commande de la pile à combustible 100 comprend en outre un module de commande et de traitement 216. Le module de commande et de traitement 216 correspond, par exemple, à un ordinateur ou à un microcontrôleur, et peut comprendre un microprocesseur. Le module de commande et de traitement 216 est relié aux capteurs magnétiques 302, à la pompe 204, à l'humidificateur 206, au dispositif d'évacuation d'air 208, au dispositif d'alimentation en hydrogène 210, au dispositif d'évacuation d'hydrogène 212, et à la charge commandable 214.

Le dispositif de mesure de champ magnétique 300 comprend des capteurs magnétiques 302. Chaque capteur magnétique 302 est sensible au champ magnétique émis par la pile à combustible 100 et est configuré pour réaliser des mesures du champ magnétique à la position où il se trouve.

Selon un mode de réalisation, le dispositif de mesure de champ magnétique 300 comprend au moins un capteur matriciel 304 comprenant un support 306 et une matrice de capteurs magnétiques 302 agencés sur le support 306, par exemple en lignes et en colonnes. Le capteur matriciel 304 est disposé autour de la circonférence de la pile à combustible 100. Le capteur matriciel 304 est fixe par rapport à la pile à combustible 100.

Dans le mode de réalisation illustré en figure 2, la pile à combustible 100 a une section droite rectangulaire et comprend quatre faces extérieures latérales 120 et deux faces d'extrémité 122 opposées, et le dispositif de mesure de champ magnétique 300 comprend quatre capteurs matriciels 304, chaque capteur matriciel 304 étant situé en face de l'une des faces extérieures latérales 120. Chaque capteur matriciel 304 est fixe par rapport à la pile à combustible 100. Les capteurs magnétiques 302 peuvent être disposés à distance des faces extérieures latérales 212 ou au contact des faces extérieures latérales 212, un séparateur isolant électriquement pouvant alors être interposé entre les faces extérieures latérales 212 et les capteurs magnétiques 302.

A titre de variante, le dispositif de mesure de champ magnétique 300 peut comprendre seulement deux capteurs matriciels 304, chaque capteur matriciel 304 étant situé en face de l'une des faces extérieures latérales 120, les deux capteurs matriciels 304 étant par exemple situés sur deux faces extérieures latérales 120 opposées. A titre de variante, le dispositif de mesure de champ magnétique 300 peut comprendre seulement trois capteurs matriciels 304, chaque capteur matriciel 304 étant situé en face de l'une des faces extérieures latérales 120.

On a en outre représenté en figure 2 la direction du courant I circulant dans la pile à combustible 100 ainsi que la forme générale des lignes du champ magnétique B produit par la pile à combustible 100.

Selon un mode de réalisation, chaque capteur magnétique 302 est un capteur magnétorésistif. Un capteur magnétorésistif comprend une couche ferromagnétique dont la résistance électrique est modifiée en présence d'un champ magnétique externe. Selon un mode de réalisation, chaque capteur magnétique 302 est un capteur magnétorésistif anisotrope, également appelé capteur AMR (sigle anglais pour Anisotropic MagnetoResistance). Un capteur AMR comprend une couche ferromagnétique dont la résistance électrique est modifiée en fonction de l'orientation d'un champ magnétique externe par rapport au capteur. Selon un mode de réalisation, chaque capteur magnétique 302 est un capteur à magnétorésistance à effet tunnel, également capteur TMR (sigle anglais pour Tunnel MagnetoResistance). Un capteur TMR comprend deux couches ferromagnétiques prenant en sandwich une fine couche isolante de quelques atomes. En présence d'un champ magnétique, le passage d'électron à travers la couche isolante par effet tunnel est facilité. Selon un mode de réalisation, chaque capteur magnétique 302 correspond à un microsystème électromécanique, également appelé MEMS (sigle anglais pour micro-electromechanical system) qui est un microsystème fabriqué à partir de matériaux semiconducteurs. Chaque capteur magnétique 302 peut être contenu dans un parallélépipède dont la hauteur mesure entre 0,1 mm et 10 mm et les côtés mesurent entre 1 mm et 50 mm.

Selon un mode de réalisation, le support 306 correspond à un circuit imprimé sur une face duquel sont fixés les capteurs magnétiques 302. Selon un mode de réalisation, d'autres composants électroniques peuvent être fixés sur le support 306 pour former un circuit électronique. Selon un mode de réalisation, le circuit électronique peut réaliser un traitement sur les signaux fournis par les capteurs magnétiques 302 et transmettre des signaux traités au module de commande et de traitement 216. Selon un mode de réalisation, le traitement correspond à une opération de filtrage fréquentiel des signaux fournis par les capteurs magnétiques 302

Selon un mode de réalisation, le module de commande et de traitement 216 est configuré pour commander la charge commandable 214 pour appliquer une impédance de valeur déterminée aux bornes de la pile à combustible 100. Selon un exemple, la charge commandable 214 est une charge électronique commandable. Selon un autre exemple, la charge commandable 214 comprend un ensemble de résistances qui, en fonction de signaux de commande fournis par le module de commande et de traitement 216, peuvent être connectées entre elles en série et/ou en parallèle entre deux bornes de la charge commandable 214 connectées aux bornes de la pile à combustible 100. Le module de commande et de traitement 216 peut, en outre, être configuré pour commander la charge commandable 214 pour appliquer une inductance et/ou une capacité de valeurs déterminées aux bornes de la pile à combustible 100.

Le dispositif 200 de commande de la pile à combustible 100 permet d'assurer le fonctionnement de la pile à combustible. La pompe à air 204 peut être équipée d'une vanne de régulation de pression ou de débit d'air et fonctionne pour fournir de l'air à l'humidificateur 206. L'humidificateur 206 humidifie l'air et l'alimente vers chacune des piles à combustible élémentaires 102. L'humidificateur 206 peut être équipé d'un régulateur d'humidité. Le dispositif d'évacuation d'air 208 se connecte à chaque pile à combustible élémentaire 102. Le dispositif d'alimentation en hydrogène 210 peut comprendre une pompe ou une vanne de régulation de pression ou de débit et un humidificateur et fonctionne pour fournir le gaz hydrogène provenant d'un réservoir d'hydrogène (non représenté) à chaque pile à combustible élémentaire 102. Le dispositif d'alimentation en hydrogène 210 peut être équipé d'un régulateur d'humidité. Le dispositif d'évacuation d'hydrogène 212 se connecte à chaque pile à combustible élémentaire 102. Le dispositif 200 de commande de la pile à combustible 100 peut en outre comprendre un dispositif de refroidissement, non représenté, de la pile à combustible 100 comprenant des conduites pour la circulation d'un liquide de refroidissement.

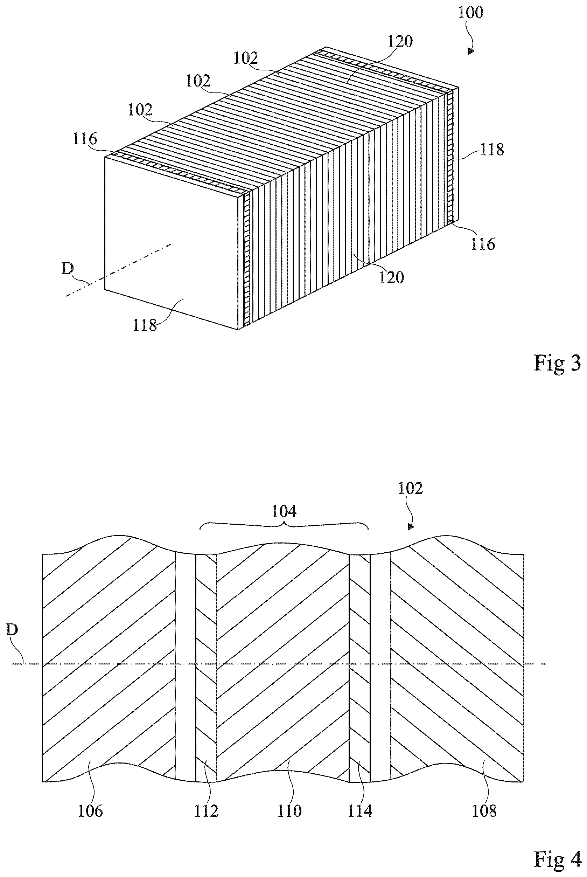

La figure 3 est une vue en perspective, partielle et schématique, de la pile à combustible 100 de la figure 1 et la figure 4 est une vue en coupe, partielle et schématique, de la pile à combustible 100 de la figure 3.

Chaque pile à combustible élémentaire 102 est, par exemple, une pile à combustible à polymère solide et, comme cela est illustré en figure 4 comprend un ensemble d'assemblage membrane électrode 104, une plaque de distribution d'air 106 et une plaque de distribution de combustible 108.

L'assemblage membrane électrode 104 comprend une membrane perméable aux ions 110, une couche d'électrode à air 112 (la cathode) et une couche d'électrode à combustible 114 (l'anode). La couche d'électrode à air 112 et la couche d'électrode à combustible 114 sont fixées sur des faces opposées de la membrane 110. En fonctionnement, une réaction d'oxydation de l'hydrogène produisant des protons a lieu à l'anode 114 et une réaction de réduction de l'oxygène produisant de l'eau a lieu à la cathode 112.

L'assemblage membrane électrode 104 est pris en sandwich entre les plaques 106 et 108. Chaque plaque 106 et 108 est constituée d'un matériau conducteur et sert de plaque terminale d'électrode pour la pile à combustible élémentaire 102. Plus précisément, la plaque de distribution de combustible 108 sert de borne d'électrode négative (-) et la plaque de distribution d'air 106 sert de borne d'électrode positive (+). En outre, la plaque de distribution de combustible 108 comprend des canaux, non représentés, pour la distribution du combustible et la plaque de distribution d'air 106 comprend des canaux, non représentés, pour la distribution d'air. En général, la plaque de distribution d'air 106 d'une première pile à combustible élémentaire 102 et la plaque de distribution de combustible 108 d'une deuxième pile à combustible élémentaire 102 adjacente à la première pile à combustible élémentaire correspondent à une seule pièce, appelée plaque bipolaire. Chaque plaque 106 et 108 est, en pratique, beaucoup plus épaisse que la membrane 110. Par exemple, chaque plaque 106 et 108 a une épaisseur de 1 mm à 2 mm. Chaque assemblage membrane électrode 104 peut éventuellement comprendre des couches de diffusion de gaz et des couches de catalyseurs et a une épaisseur totale d'environ 0,5 mm.

La pile à combustible 100 comprend également des plaques collectrices de courant 116 fixées aux extrémités de l'empilement de piles à combustible élémentaires 102. Les plaques collectrices de courant 116 sont chacune constituées d'une plaque métallique, par exemple de section carrée ou rectangulaire, et comportent des bornes (non représentées) s'étendant vers l'extérieur de la pile à combustible 100, par exemple dans une direction perpendiculaire à la direction longitudinale D. Les plaques collectrices de courant 116 sont reliées respectivement aux électrodes 112 et 114 des deux piles à combustible élémentaires 102 situées aux extrémités de la pile à combustible 100.

Lors de l'assemblage, la pile à combustible 100 est comprimée depuis l'extérieur des plaques collectrices de courant 116 par des plaques de maintien 118 et des plaques isolantes, non représentées, recouvrant les faces latérales externes 120 pour assurer l'étanchéité à l'air de la pile à combustible 100 et le contact électrique entre les piles à combustible élémentaires 102.

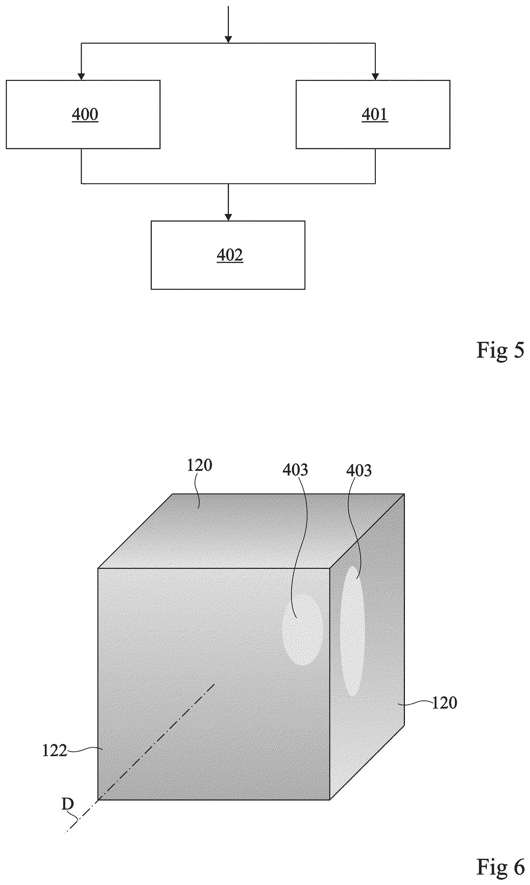

La figure 5 est un schéma par blocs illustrant un mode de réalisation d'un procédé de détermination de la densité de courant dans une pile à combustible 100 mettant en oeuvre le dispositif 200 de commande de la pile à combustible 100 et le dispositif 300 de mesure de champ magnétique de la figure 1.

A l'étape 400, le module de commande et de traitement 216 commande la charge 214 pour faire varier l'intensité du courant I fourni par la pile à combustible 100 selon une forme d'onde déterminée. Le module de commande et de traitement 216 fonctionne pour contrôler les opérations du régulateur de débit d'hydrogène du dispositif d'alimentation en hydrogène 210, du régulateur de débit d'air de la pompe à air 204 et des régulateurs de débit d'humidité du dispositif d'alimentation en hydrogène 210 et de l'humidificateur 206 pour réguler le débit du gaz hydrogène et de l'air et la quantité d'humidité contenue dans le gaz hydrogène et l'air, de manière sélective.

A l'étape 401, qui se déroule simultanément à l'étape 400, chaque capteur magnétique 302 fait l'acquisition de mesures successives du champ magnétique au cours de la variation du courant I. Les mesures de champ magnétique sont transmises au modules de commande et de traitement 216, éventuellement après qu'un traitement a été appliqué à ces mesures.

A l'étape 402, qui peut être en partie simultanée avec les étapes 401 et 402, le module de commande et de traitement 216 détermine la densité de courant dans une pile à combustible 100 à des instants successifs à partir des mesures acquises par les capteurs magnétiques 302. Selon un mode de réalisation, la densité de courant est déterminée par inversion d'un modèle de comportement magnétique de la pile à combustible 100 à partir des mesures de champ magnétique acquises par les capteurs magnétiques 302.

Selon un mode de réalisation, à l'étape 402, le module de commande et de traitement 216 peut fonctionner pour analyser un changement de densité de flux magnétique, tel que détecté par les capteurs magnétiques 302 pour déterminer la distribution de courant dans la pile à combustible 100, trouver un facteur (par exemple, une baisse de performance de la pile à combustible 100) entraînant une variation locale ou une non-uniformité de la distribution de courant, et réguler le débit de l'hydrogène gazeux ou de l'air ou la quantité d'humidité contenue dans l'hydrogène gazeux ou l'air qui doit être fourni à la pile à combustible 100 pour éliminer la non-uniformité de la distribution de courant.

La figure 6 est une image schématique en niveaux de gris d'un exemple de densité de courant dans une pile à combustible obtenue à un instant donné à l'étape 402. En figure 6, on a représenté schématiquement la densité de courant sur deux faces latérales externes 120 et sur une face avant 122 de la pile à combustible 100. Deux zones 403 sont représentées apparaissent, l'une sur la face avant 122 et l'autre sur l'une des faces latérales externes 120 et traduisent une inhomogénéité de la densité de courant.

Selon un mode de réalisation, à l'étape 400, le module de commande et de traitement 216 commande la charge 214 pour faire varier l'intensité du courant I fourni par la pile à combustible 100 en fréquence et/ou en amplitude et/ou en forme d'onde pour améliorer les performances des capteurs de champ magnétique 302. Selon un mode de réalisation, à l'étape 402, un filtrage est réalisé sur les mesures acquises par les capteurs de champ magnétique 302. Selon un mode de réalisation, la charge 214 est commandée pour que l'intensité du courant I fourni par la pile à combustible 100 varie dans une plage de fréquences autour d'une fréquence d'excitation et les mesures de champ magnétique fournies par les capteurs de champ magnétique 302 sont filtrés par un filtrage passe-bande dont la zone de sélectivité est située autour de la fréquence d'excitation. De préférence, le filtrage est préférablement appliqué au niveau du capteur matriciel 304 avant transmission de signaux au module de commande et de traitement 216.

Le fait de faire varier de façon déterminée l'intensité du courant I circulant dans la pile à combustible 100, qui joue alors le rôle d'un signal d'excitation, permet d'améliorer le rapport signal sur bruit des mesures obtenues par les capteurs magnétiques 302 et même de s'affranchir des sources de perturbations de l'environnement (champs magnétique terrestre, moteurs, vannes, etc.) par un traitement, notamment un filtrage fréquentiel, appliqué aux mesures de champ magnétique fournies par les capteurs magnétiques 302.

Selon un mode de réalisation, le module de commande et de traitement 216 commande la charge 214 pour faire varier l'intensité du courant I fourni par la pile à combustible 100 selon une forme d'onde déterminée, en particulier une forme d'onde sinusoïdale, une forme d'onde carrée, une forme d'onde obtenue à partir d'une séquence binaire pseudo-aléatoire, etc.

Selon un mode de réalisation, le module de commande et de traitement 216 commande la charge 214 pour faire varier l'intensité du courant I en amplitude selon une forme d'onde sinusoïdale, de préférence à une fréquence comprise entre 0,1 kHz et 20 kHz et une variation d'amplitude entre 1 % et 10 % de l'intensité du courant nominal. Ce mode de réalisation permet, de façon avantageuse, de pourvoir réaliser le filtrage des mesures de champ magnétiques de façon simple.

Selon un mode de réalisation, le module de commande et de traitement 216 commande la charge 214 pour faire varier l'intensité du courant I en amplitude selon une forme carrée, de préférence périodique. Ce mode de réalisation permet, de façon avantageuse, d'obtenir de façon simple la forme d'onde de l'intensité du courant I puisqu'il suffit de faire alterner de façon périodique l'impédance de la charge 214 entre deux valeurs d'impédance.

Selon un mode de réalisation, le module de commande et de traitement 216 commande la charge 214 pour faire varier l'intensité du courant I selon une forme d'onde obtenue en faisant varier l'impédance de la charge 214 entre deux valeurs d'impédance selon une séquence binaire pseudo-aléatoire. Ceci permet de réaliser une excitation large bande . Dans ce mode de réalisation, les mesures magnétiques obtenues en faisant varier l'intensité du courant I de cette façon peuvent notamment être comparées à des mesures magnétiques obtenues sans faire varier le courant.

Selon un mode de réalisation, le module de commande et de traitement 216 commande la charge 214 pour faire varier la fréquence de l'intensité du courant I fourni par la pile à combustible 100 sur une large plage de fréquences afin d'obtenir une spectroscopie magnétique de la pile à combustible 100, c'est-à-dire l'évolution du champ magnétique émis par la pile à combustible 100 en fonction de la fréquence du courant I. La totalité de l'intensité du courant I peut être modulée en fréquence, ou l'intensité du courant I peut être la somme d'une composante constante et d'une composante variable, la composante variable étant modulée en fréquence et restant toujours dans la plage de plus ou moins 10 % de la composante continue. Dans ce but, selon un mode de réalisation, le module de commande et de traitement 216 commande la charge 214 pour faire varier l'intensité du courant I fourni par la pile à combustible 100 à une fréquence fixe pendant une durée déterminée par le nombre de périodes d'excitation que l'on souhaite appliquer, puis le module de commande et de traitement 216 commande la charge 214 pour modifier la fréquence fixe de variation de l'intensité du courant I fourni par la pile à combustible. L'opération est répétée de façon à balayer toute la plage de fréquences désirée pour la spectroscopie magnétique.

Selon un mode de réalisation, les déclenchements des mesures de champ magnétique par les capteurs magnétiques 302 et la variation de l'intensité du courant I fourni par la pile à combustible 100 sont synchronisés lorsque qu'une spectroscopie du champ magnétique est réalisée pour permettre de mesurer le déphasage du champ magnétique en plus de l'amplitude du champ magnétique. La contrainte de synchronisation temporelle dépend alors de la fréquence d'excitation de l'intensité du courant I utilisée. Plus la fréquence d'excitation est élevée, plus l'erreur de temps de synchronisation doit être faible proportionnellement. De préférence, la synchronisation est inférieure à 1 µs pour une fréquence de 500 Hz. Lorsqu'un filtrage des mesures de champ magnétique est réalisé, le déphasage introduit par le filtrage doit en outre être pris en compte.

Pour certaines applications, notamment pour l'optimisation du contrôle de la pile à combustible, il est souhaitable de déterminer une estimation du taux d'hydratation des membranes 110 échangeuses de proton des piles à combustible élémentaires 102. Une telle estimation peut être effectuée à partir d'une mesure d'impédance électrique qui reposent sur le couplage d'une mesure du courant traversant la pile à combustible avec la mesure de tension aux bornes de la pile à combustible ou d'une partie de l'empilement de piles à combustible élémentaires 102.

En effet, la réaction dans chaque pile à combustible élémentaire 102 crée de l'eau. Une excès d'humidité dans la pile à combustible perturbe généralement la réaction, entraînant ainsi une baisse de la capacité de la pile à combustible 100 à générer de l'électricité. Il est donc nécessaire de maintenir la quantité d'humidité dans une plage limitée dans chaque pile à combustible élémentaire 102.

Même si la température, la pression ou l'humidification des gaz à fournir à la pile à combustible 100 sont contrôlées pour maintenir le fonctionnement de la pile à combustible dans un état souhaité, l'une quelconque des piles à combustible élémentaires 102 peut être partiellement hors des conditions requises. Dans un tel cas, l'une des piles à combustible élémentaires 102 peut ne pas parvenir à générer l'énergie électrique requise, ce qui entraîne une diminution de sa surface de production d'électricité. Cela accélère le vieillissement de la zone de production d'électricité, ce qui entraîne une diminution de la durée de vie totale de la pile à combustible 100. Il est donc essentiel de maintenir l'humidité dans chacune des piles à combustible élémentaires 102 à un niveau requis.

La figure 6 est un schéma d'un autre mode de réalisation d'un système 500 comprenant une pile à combustible et un dispositif de mesure du champ magnétique dans la pile à combustible. Le système 500 comprend l'ensemble des éléments du système 10 représenté sur les figures 1 et 2, seuls la pile à combustible 100 et le dispositif de mesure 300 du champ magnétique dans la pile à combustible 100 du système 10 étant représenté en figure 6.

Le système 500 comprend en outre un capteur de courant 501 configuré pour mesurer l'intensité du courant I fourni par la pile à combustible 100 et au moins des capteurs de potentiel 504 configurés pour mesurer la différence de potentiels U de l'empilement de piles à combustible élémentaires 102 entre deux piles à combustible élémentaires 102 de l'empilement. Le capteur de courant 501 et les capteurs de potentiel 504 sont reliés au module de commande et de traitement 216.

Selon un mode de réalisation, les capteurs de potentiel 504 peuvent être déplacés sur la pile à combustible pour mesurer la tension U de l'empilement de piles à combustible élémentaires 102 entre deux piles à combustible élémentaires 102 situées à des positions quelconques de l'empilement de piles à combustible élémentaires 102. A titre d'exemple, les deux piles à combustible élémentaires 102 peuvent être adjacentes. Dans ce cas, les capteurs de potentiel 504 sont configurés pour déterminer la tension U entre ces deux piles à combustible élémentaires 102 adjacentes. Selon un autre exemple, les deux piles à combustible élémentaires 102 peuvent correspondre respectivement à la première pile à combustible élémentaire 102 de la pile à combustible 100 et à la dernière pile à combustible élémentaire 102 de la pile à combustible 100. Dans ce cas, les capteurs de potentiel 504 sont configurés pour déterminer la tension aux bornes de l'ensemble de la pile à combustible 100.

Le module de commande et de traitement 216 est configuré pour déterminer une valeur d'impédance d'un empilement de piles à combustible élémentaires 102 à partir de la mesure du courant I fourni par la pile à combustible 100 et de la mesure de la tension U de l'empilement de piles à combustible élémentaires 102. Le module de commande et de traitement 216 est alors configuré pour déterminer une estimation du taux d'hydratation des membranes 101 des piles à combustible élémentaires 102 de l'empilement de piles à combustible élémentaires 102.

Selon un mode de réalisation, la détermination de l'impédance est réalisée simultanément à la détermination de la densité de courant dans la pile à combustible 100. Dans le mode de réalisation du procédé de détermination de la densité de courant dans une pile à combustible 100 décrit précédemment en relation avec la figure 5, la mesure du courant I et la mesure de la tension U peuvent être effectuées à l'étape 400 au cours de la variation du courant fourni par la pile à combustible 100 qui résulte de la commande de la charge 214 par le module de commande et de traitement 216. En outre, la détermination de l'impédance est réalisée à l'étape 402 simultanément à la détermination de la densité de courant. Il faut alors synchroniser l'excitation en courant, la mesure du champ magnétique et la mesure de tension à l'étape 400.

Selon un mode de réalisation, le module de commande et de traitement 216 commande la charge 214 pour faire varier la fréquence du courant I fourni par la pile à combustible 100 sur une plage de fréquences afin d'obtenir une spectroscopie d'impédance, c'est-à-dire l'évolution de l'impédance en fonction de la fréquence du courant I, de la pile à combustible 100 complète ou d'un empilement d'une partie des piles à combustible élémentaires 102 de la pile à combustible 100.

Selon un autre mode de réalisation, le dispositif 300 de mesure de champ magnétique de la figure 1 est configuré pour déterminer un défaut de fonctionnement de la pile à combustible 100 par comparaison du champ magnétique, ou d'une signature obtenue à partir du champ magnétique, avec le champ magnétique (ou la signature) obtenu pour une pile à combustible en bon état de fonctionnement.

Des modes de réalisation d'un dispositif et d'un procédé de mesure de champ magnétique dans un objet ont été décrits dans le cas où l'objet correspond à une pile à combustible. Toutefois, il est clair que ces modes de réalisation de dispositif et de procédé de mesure de champ magnétique peuvent être mis en oeuvre pour un objet différent d'un pile à combustible, par exemple un électrolyseur ou une batterie d'accumulateurs électriques.

Un électrolyseur est un appareil qui utilise l'électricité pour diviser l'eau ou d'autres composants en leurs éléments constitutifs par électrolyse. L'électrolyse est une réaction chimique dans laquelle un courant électrique amène à décomposer une substance en différents composants. Dans le cas de l'électrolyse de l'eau, un électrolyseur utilise un courant électrique pour diviser les molécules d'eau en gaz hydrogène et oxygène. Un électrolyseur comprend généralement un empilement d'électrolyseurs élémentaires. Chaque électrolyseur élémentaire comprend deux électrodes - une cathode et une anode - séparées par un électrolyte. Lorsqu'un courant électrique est appliqué à travers l'électrolyseur élémentaire, la réaction d'oxydation ayant lieu à l'anode conduit au dégagement d'oxygène gazeux (O₂) et la réaction de réduction ayant lieu à la cathode libère de l'hydrogène gazeux (H₂).

Le système 10 décrit précédemment en relation avec les figures 1 et 2 peut être mis en oeuvre pour déterminer le champ magnétique émis par l'électrolyseur. Le système 500 décrit précédemment en relation avec la figure 6 peut être mis en oeuvre pour déterminer le champ magnétique émis par l'électrolyseur et pour déterminer l'impédance de l'électrolyseur.

Pour des électrolyseurs dit à basse température, les capteurs matriciels 304 peuvent être disposés directement sur l'électrolyseur de manière analogue à ce qui a été décrit précédemment pour la pile à combustible. Pour des électrolyseurs dit à haute température, l'électrolyseur est disposé dans une enceinte d'isolation thermique, de sorte que les capteurs matriciels 304 ne peuvent pas être disposés directement sur l'électrolyseur, ce qui entraîne une décroissance forte du rapport signal sur bruit des mesures fournies par les capteurs magnétiques 302. L'utilisation du système 10 ou 500 décrit précédemment permet la détermination de la densité de courant malgré le faible rapport signal sur bruit des mesures de champ magnétique.

Un accumulateur électrique est un système de stockage de l'énergie électrique sous une forme différente. Il repose sur une technique de conversion réversible d'énergie. Les processus de conversion d'énergie sont complexes et entraînent des pertes. Une batterie d'accumulateurs électriques comprend un empilement d'accumulateurs électriques élémentaires.

Le système 10 décrit précédemment en relation avec les figures 1 et 2 peut être mis en oeuvre pour déterminer le champ magnétique émis par la batterie d'accumulateurs électriques. Ceci permet notamment d'observer le comportement des accumulateurs électriques, par exemple pour caractériser leur comportement et/ou détecter des défauts internes. En particulier, le capteurs magnétiques 302 peuvent être disposés en surface d'un seul accumulateur électrique et/ou entre deux accumulateurs électriques. Le système 500 décrit précédemment en relation avec la figure 6 peut être mis en oeuvre pour déterminer le champ magnétique émis par la batterie d'accumulateurs électriques et pour déterminer l'impédance d'accumulateurs électriques ou la distribution de courant à l'intérieur d'un accumulateur électrique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Système (100) comprenant un objet (100) et un dispositif (300) de mesure d'un champ magnétique (B) émis par l'objet (100), l'objet (100) comprenant au moins des premières et deuxièmes faces latérales externes (120), le dispositif (300) de mesure du champ magnétique (B) comprenant :
- un capteur matriciel (304) sur chacune des première et deuxième faces latérales externes (120), chaque capteur matriciel (304) comprenant une matrice de capteurs magnétiques (302) configurés pour acquérir des mesures successives du champ magnétique (B) ;
- une charge commandable (314) connectée électriquement à l'objet (100) ; et
- un module (216) configuré pour commander la charge commandable (314) pour faire varier le courant (I) circulant dans l'objet (100) au cours des acquisitions des mesures successives du champ magnétique (B) et pour recevoir les mesures successives du champ magnétique (B).

2. Système selon la revendications 1, dans lequel chaque matrice (304) de capteurs magnétiques (302) comprend un circuit électronique de filtrage des mesures successives du champ magnétique (B).

3. Système selon la revendication 1 ou 2, comprenant en outre un capteur (502) de l'intensité du courant (I) circulant dans l'objet (100) et un capteur de tension (504) destiné à mesurer la tension (U) entre deux éléments (102) de l'objet (100).

4. Système selon l'une quelconque des revendications 1 à 3, dans lequel l'objet (100) comprend quatre faces latérales externes (120) et dans lequel le dispositif (300) de mesure du champ magnétique (B) comprend un capteur matriciel (304) sur chaque face latérale externe (120).

5. Système selon l'une quelconque des revendications 1 à 4, dans lequel l'objet est une pile à combustible (100), un électrolyseur, ou une batterie d'accumulateurs électriques.

6. Système selon la revendication 3, le capteur de tension (504) étant configuré pour mesurer la tension entre deux éléments (102) de l'objet (100) au cours de la variation du courant (I) circulant dans l'objet (100).

7. Système selon l'une quelconque des revendications 1 à 6, dans lequel les capteurs magnétiques (302) sont fixes par rapport à l'objet (100) pendant l'acquisition de mesures successives du champ magnétique (B).

8. Procédé de mesure d'un champ magnétique (B) émis par un objet (100) l'objet (100) comprenant au moins des premières et deuxièmes faces latérales externes (120), le procédé comprenant la connexion électrique d'une charge commandable (314) à l'objet (100), l'acquisition de mesures successives du champ magnétique (B) par des capteurs magnétiques (302) d'un capteur matriciel (304) sur chacune des première et deuxième faces latérales externes (120), chaque capteur matriciel (304) comprenant une matrice desdits capteurs magnétiques (302), et la commande de la charge commandable (314) pour faire varier le courant (I) circulant dans l'objet (100) au cours des acquisitions des mesures successives du champ magnétique (B).

9. Procédé selon la revendication 8, comprenant le filtrage fréquentiel des mesures successives du champ magnétique (B).

10. Procédé selon la revendication 8 ou 9, comprenant la détermination de la densité de courant dans l'objet (100) à partir des mesures successives du champ magnétique (B).

11. Procédé selon l'une quelconque des revendications 8 à 10, comprenant les mesures successives du courant (I) circulant dans l'objet (100) et de la tension (U) entre deux éléments (102) de l'objet (100) au cours de la variation du courant (I) circulant dans l'objet (100) et la détermination d'une impédance à partir des mesures du courant (I) et de la tension (U).

12. Procédé selon l'une quelconque des revendications 8 à 11, dans lequel le courant (I) varie selon une forme d'onde sinusoïdale, ou carrée, ou alternant entre deux valeurs selon une séquence pseudo-aléatoire.

13. Procédé selon l'une quelconque des revendications 8 à 12, dans lequel les capteurs magnétiques (302) sont fixes par rapport à l'objet (100) pendant l'acquisition de mesures successives du champ magnétique (B).
